# EUROPEAN PATENT SPECIFICATION

(11) **EP 4 047 250 B1**
(45) Date of publication and mention of the grant of the patent: **29.11.2023**
(21) Application number: 21158383.6
(22) Date of filing: 22.02.2021
(51) Int. Cl.: H01L 21/687, H01F 7/08, H01F 7/122, H01F 7/13, H01F 7/16

(54) **MAGNETIC Z-ACTUATOR AND WAFER HOLDER COMPRISING SUCH ACTUATOR**
MAGNETISCHER Z-AKTUATOR UND WAFER-HALTER MIT SOLCH EINEM AKTUATOR
ACTIONNEUR Z MAGNÉTIQUE ET SUPPORT DE TRANCHE COMPRENANT UN TEL ACTIONNEUR

(43) Date of publication of application: 24.08.2022
(73) Proprietor: ETEL S.A., 2112 Môtiers (CH)
(72) Inventor: Mittal, Manish, 2000 Neuchâtel (CH); Chechenev, Dmitry, 2000 Neuchâtel (CH); Sivignon, Eric, 2112 Môtiers (CH)
(74) Representative: P&TS SA (AG, Ltd.)

(56) References cited:
- FR-A1- 2 940 500
- RU-C1- 2 233 495
- US-A1- 2017 074 418

## Description

### Field of the invention

The present invention, which is defined by the appended claims, relates generally to semiconductor processing equipment and more particularly to a magnetic Z-actuator which may be integrated for example into a wafer holder below a wafer chuck for lifting a pin assembly so as to raise a wafer off the chuck surface for removal of the wafer from the wafer holder.

### Background of the invention

Wafer chucks are often used to hold wafers in place while they are being tested. Most wafers are held in place by applying a small amount of vacuum to the backside of the wafer. Once the processing is completed, the wafer needs to be unloaded from the chuck. To that effect, the wafer chuck comprises a pin assembly comprising several pins positioned on corresponding holes on the chuck surface to form a continuous substantially flat surface with the rest of the chuck surface. These pins are configured to be actuated in a Z-direction to raise the wafer off the chuck surface so that a wafer removing tool can be inserted under the wafer to remove it from the chuck.

The following documents are mentioned, as a pertinent prior art illustration:

US2017/074418A1 relates to a high-power bi-directional no-recovery spring electromagnetic valve with a permanent magnet.

FR2940500A1 discloses an electromagnetic bistable actuator.

RU2233495C1 discloses an electromagnetic drive.

Additional prior art documents are also further mentioned below.

US2006/061219A1 discloses an actuator device suitable for actuating a stage, for receiving wafers, relative to a z-axis and supporting the weight of the stage against the force of gravity. The actuator device includes a first arrangement, a magnetic system, a piston, and a guide bearing arrangement. The first arrangement includes a yoke and a center pole, and the magnetic system includes a magnet that is coupled to the yoke as well as a coil which cooperate to function as a voice coil motor. The piston supports at least a weight associated with the first arrangement, and the guide bearing arrangement includes a planar air bearing that enables the device to move over an external surface.

US9172291 B2 discloses a vertical actuator having gravity compensation. The vertical actuator comprises a first subassembly and a second subassembly. One of the two subassemblies is stationary and the other of the two subassemblies is movable in the vertical direction. The first subassembly has a first magnetic yoke provided with a coil, and the second subassembly has a second magnetic yoke provided with at least one magnet which is oriented toward the coil. A horizontal gap between the first and second magnetic yokes in the region of the at least one magnet is variable in the vertical direction, so that a reluctance force acts between the first and second subassemblies in an operating range of the actuator. This vertical actuator is used in particular for positioning a worktable or a stage as precisely as possible in the vertical direction.

These Z-axis actuators have the disadvantage to require continuous supply of current to provide a constant push force for preloading hard stops to ensure high accuracy positioning of the stage. This involves heat generation which may cause deformation leading to degradation in positioning accuracy over time. An additional push force device can be a solution, but it adds cost, space, and complexity to the system.

US9890871A discloses a vertical actuator comprising a stationary assembly and a movable assembly. The stationary assembly comprises an upper magnetic circuit part comprising an upper coil and lower magnetic circuit part comprising a lower coil. The upper and lower magnetic circuit parts are symmetrically disposed and connected together by an armature. The movable assembly comprises upper and lower iron cores connected by a rod which protrudes through two opposite holes on the armature. The movable assembly is actuable relatively to the stationary assembly from a lower axial position to an upper axial position and vice versa.

The above vertical actuator requires to power the upper and lower coils only to switch the movable assembly from one to the other of its two lower and upper axial positions.

This vertical actuator is however bulky which may pose integration issues depending on the room constraint on a particular device which requires a magnetic Z actuator. Moreover, the actuator is made of multiple parts which has a negative impact on its overall cost. In addition, although the actuator is configured such that it generates a holding force without energizing the coils, this holding force appears to be just high enough to only compensate the gravity force without additional force to preload hard stops for high accuracy positioning.

An aim of the present invention is therefore to provide a magnetic Z-actuator that is compact and easy to manufacture at a reduced cost.

Another aim of the present invention is to provide a magnetic Z-actuator configured for applying, without any current, a constant force high enough for applying a preload ranging for example from 30N to 90N resulting in high accuracy positioning.

A further aim of the present invention is to provide a magnetic Z-actuator with improved actuating force, ensuring improved dynamic movement of the actuator.

### Brief summary of the invention

These aims are achieved by a magnetic Z-actuator comprising a stationary assembly and a mobile assembly configured to move relatively to the stationary assembly from a first to a second stable axial position and vice versa. The stationary assembly comprises a first and a second magnetic yokes and a first and a second coils at least partially embedded in respective first and second magnetic yokes. The mobile assembly comprises permanent magnets. The magnetic Z-actuator is configured such that the first and second coils are energized only to move the mobile assembly from the first to the second stable axial position and vice versa. The mobile assembly remains in either the first and second stable axial positions without the need of providing current to the first and second coils.

According to the invention, the mobile assembly comprises a mobile magnetic yoke, and a first and a second permanent magnets mounted on the mobile magnetic yoke to face a bottom surface of respective first and second magnetic yokes.

In an embodiment, the mobile assembly is substantially T-shaped.

In an embodiment, the mobile assembly comprises a frame, and a third and fourth permanent magnets mounted in the frame. The frame and the third and fourth magnets are arranged to move between the first and second magnetic yokes.

In an embodiment, the frame is made of a non-magnetic material.

In an embodiment, the frame comprises an interface portion. The third and fourth permanent magnets are mounted on both sides of the interface portion.

In an embodiment, the first, second, third and fourth permanent magnets are rectangular parallelepiped-shaped magnets.

In an embodiment, the first and second permanent magnets of the mobile assembly are spaced away from the bottom surface of respective first and second magnetic yokes by a predetermined distance when the mobile assembly is in the first stable axial position. An upper portion of the frame protrudes from a top surface of said first and second magnetic yokes when the mobile assembly is in the second stable axial position.

In an embodiment, the first and second permanent magnets are magnetized in an opposite direction to form a lower magnetic circuit. The third and fourth permanent magnets are magnetized in an opposite direction to form an upper magnetic circuit when the mobile assembly is in the second stable axial position.

In an embodiment, the first and second magnetic yokes are substantially E-shaped.

In an embodiment, the upper and lower portions of the first and second magnetic yokes which face one another are chamfered.

In an embodiment, the distance *d2* between the bottom surface of respective first and second coils and the bottom surface of respective first and second magnetic yokes is at least 1.5 times greater than the distance *d1* between the top surface of respective first and second magnetic yokes and the top surface of respective first and second coils. The distance *d2* may be for example approximately two times greater than the distance *d1*.

Another aspect of the invention relates to a wafer holder comprising the magnetic Z-actuator as described above.

In an embodiment, the wafer holder further comprises a wafer holder casing, and a rotatable unit comprising a wafer chuck rotatably mounted inside the wafer holder casing and having at least three through-holes. The rotatable unit also comprises at least three pin assemblies. Each pin assembly comprises a pin mounted in a corresponding through hole of the wafer chuck and a pin holder slidably mounted on a pin holder support. An extremity of each pin holder is connected to a transmission component.

The magnetic Z-actuator is arranged to cooperate with the transmission component to move the pins from a retracted position, in which the top surface of the pins is set below or at the level of the surface of the wafer chuck, to an extended position, in which the pins protrude from their corresponding through-holes above the surface of the wafer chuck and vice versa.

In an embodiment, the transmission component is in the form of a ring adapted to cooperate with an actuating member of the magnetic Z-actuator. The actuating member is connected to two diametrically opposed portions of the transmission ring.

In an embodiment, the wafer holder further comprises upper hard stops connected to respective pin support and against which the transmission ring abuts under the thrust of the actuating member when the first and second coils of the magnetic Z-actuator are energized such that the actuating member ensures a preload on the upper hard stops within a range from 30N to 90 N.

### Brief description of the drawings

The invention will be better understood with the aid of the description of several embodiments given by way of examples and illustrated by the figures, in which:
- Figure 1 shows a cut-out view of a wafer holder integrating the magnetic Z-actuator according to an embodiment of the invention, whereby the mobile assembly of the actuator is in the middle of its stroke;
- Figure 2a shows a perspective view of the magnetic Z-actuator in an extended configuration according to an embodiment of the invention;
- Figure 2b shows a perspective view of the magnetic Z-actuator of Figure 2a in a retracted configuration;
- Figure 3 shows a schematic cross-section view of the magnetic Z-actuator of Figure 2b;
- Figure 4 shows a schematic cross-section view of the magnetic Z-actuator of Figure 2a showing the path of a first and a second magnetic circuits;
- Figure 5 shows a schematic cross-section view of the magnetic Z-actuator in an extended configuration according to another embodiment of the invention ;
- Figure 6 shows a schematic cross-section view of the magnetic Z-actuator in an extended configuration according to another embodiment of the invention ;
- Figure 7 illustrates a graph showing the actuating force along the Z-axis as a function of the stroke progression of the magnetic Z-actuator with no current supply, whereby the resultant positive force is 60 N when the Z-actuator in an extended configuration ;
- Figure 8 illustrates a graph showing the actuating force along the Z-axis as a function of the stroke progression of the magnetic Z-actuator with a positive current supply to the first and second coils of the Z-actuator, and
- Figure 9 illustrates a graph showing the actuating force along the Z-axis as a function of the stroke progression of the magnetic Z-actuator with a negative current supply to the first and second coils of the Z-actuator.

### Detailed description of several embodiments of the invention

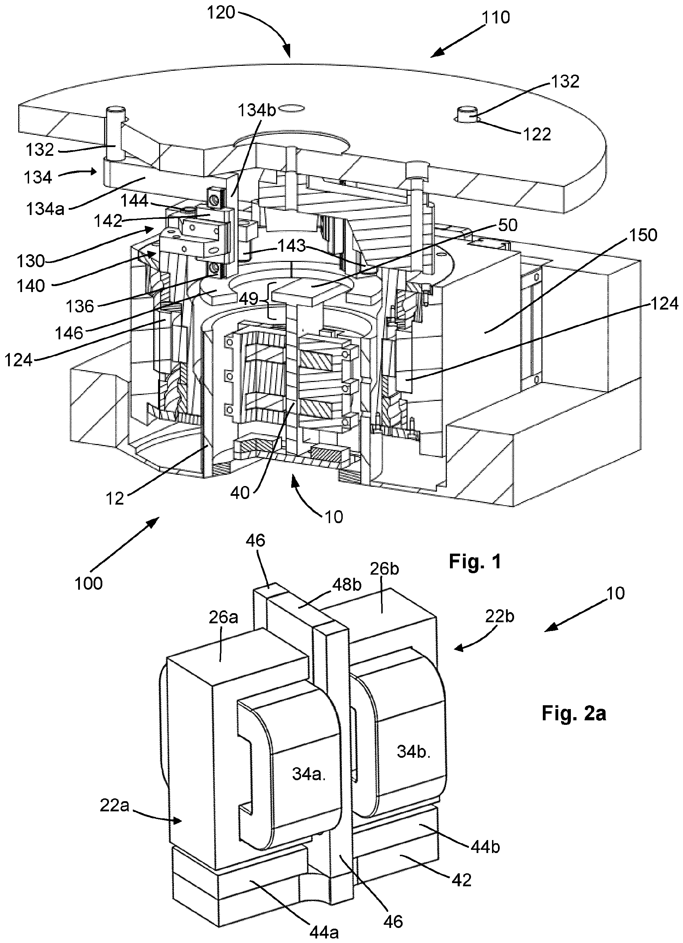

Referring to Figure 1, the magnetic Z-actuator 10 is particularly adapted to be integrated in a wafer holder 100. As it will be apparent from the description of the magnetic Z-actuator thereafter, the specific configuration of this actuator offers many advantages. In the exemplary embodiment of Figure 1, the wafer holder 100 comprises a rotatory unit 110 rotatably mounted inside a wafer holder casing 150. The rotary unit 110 comprises a wafer chuck 120 provided with through-holes 122, and several pin assemblies 130.

Each pin assembly 130 comprises a pin holder 134, for example in the shape of a L-shaped structure, with a first segment 134a oriented in a horizontal plane and a second segment 134b oriented perpendicularly to the first segment along a downward direction in a vertical plane. A pin 132 is mounted on a distal end of the first segment 134a of the L-shaped structure 134 to be in alignment with a corresponding through-hole 122 of the wafer chuck 120.

A linear bearing is fixed along the second segment 134a of the L-shaped structure 134. The linear bearing comprises a carriage 142 slidably mounted on a rail 136.

The carriage 142 is part of a pin holder support 140 mounted on a supporting structure 120 of the rotary unit 110. In this embodiment, the wafer holder 100 comprises three pin assemblies 130 and a corresponding number of pin holder supports 140 spaced apart from each other from 120° although the number of pin assemblies may vary according to other embodiments in which the number of pin assemblies and their corresponding support may be for example four.

An extremity of the second segment 134b of each pin holder 134 is fixedly connected to a transition component 146 which is preferably a ring-shaped component. The three pin assemblies 130 form together with the ring-shaped component 146 a pin unit configured to be actuated upwardly and downwardly by the magnetic Z-actuator 10 mounted in a housing 12 below the pin unit. The stroke of the Z-actuator between from extended position as shown in Figure 2a to a retracted position is vice versa is about 12mm.

As shown in Figure 1, upper and lower hard sops 143, 144 are mounted on respective pin holder support 140 to limit the upward and downward movement of the pin unit when actuated by the magnetic Z-actuator 10 so as to ensure a precise and repeatable stroke of the same magnitude.

Indeed, bringing a wafer (not shown) positioned on the wafer chuck 120 of the rotary unit 110 of the wafer holder 100 from a resting position to a lifted position must be done quickly while keeping the wafer in a defined position window. The position of the top surface of the pins 132 relative to the chuck surface is therefore a key performance parameter. One way of ensuring a reliable and precise position of the pins 132 relative to the chuck surface is to ensure a preload of the upper hard stops 143. Typical preload ranges from 30 to 90 N.

Not only does the magnetic Z-actuator 10 ensure accurate position of the top surface of the pins 132 when there are in their extended position by applying a preload on upper hard stops 144 within a range from 30N to 90N as it will explained later but the actuator 10 is also configured to apply a constant force without any current, resulting in high accuracy. Moreover, the passive push force of the actuator 10 at zero current produces magnetic flux which increases the magnetic flux of the actuator. This results in higher actuation forces, which ensures dynamic z-movement of the pins 132.

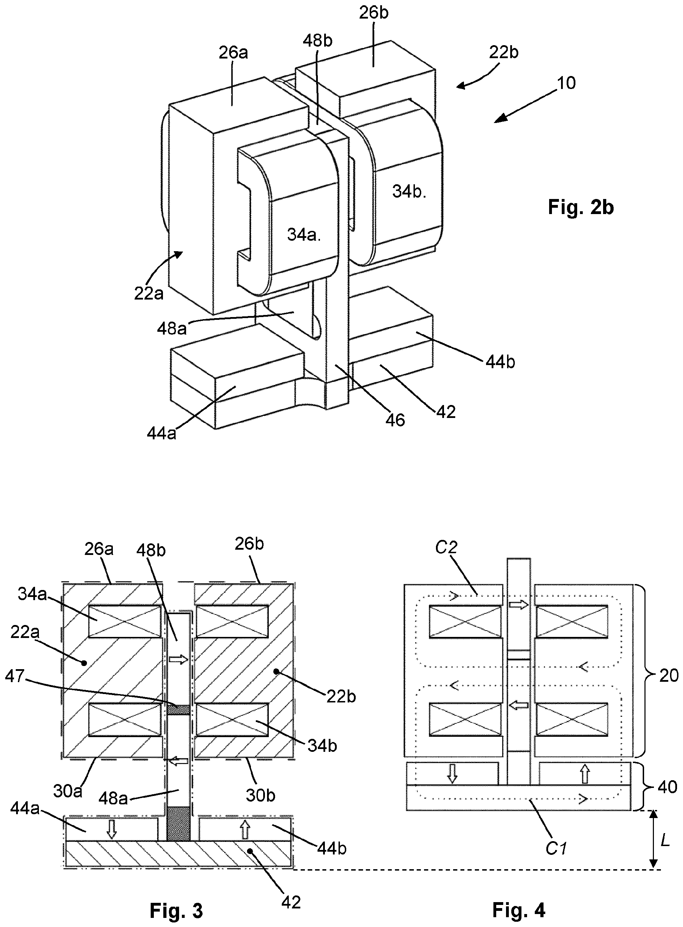

With reference to Figures 2a, 2b, 3 and 4, the magnetic Z-actuator comprises a stationary assembly 20 and a mobile assembly 40 (Figure 4) configured to move relatively to the stationary assembly 20 from a first to a second stable axial position and vice versa. As shown for example in Figures 2a, 2b, the stationary assembly comprises a first and a second magnetic yokes 22a, 22b and a first and second coils 34a, 34b partially embedded in respective first and second magnetic yokes 22a, 22b that are substantially E-shaped with the distal part of their three extensions facing each other forming a gap therebetween. The magnetic yokes 22a, 22b are typically manufactured using ferromagnetic iron sheets assembled into a lamination stack.

The mobile assembly 40 is substantially T-shaped and comprises a mobile magnetic yoke 42 having a substantially rectangular-parallelepiped shape. A first and a second substantially rectangular parallelepiped-shaped permanent magnets 44a, 44b are mounted on a top surface of the magnetic yoke 42 to face a bottom surface 30a, 30b of respective first and second magnetic yoke 22a, 22b as illustrated in Figure 3.

The mobile assembly 40 further comprises a non-magnetic frame 46 extending perpendicularly from a portion of the top surface of the magnetic yoke 42 between the first and second permanent magnets 44a, 44b through the gap between the first and second magnetic yokes 22a, 22b of the stationary assembly.

A third and fourth substantially rectangular parallelepiped-shaped permanent magnets 48a, 48b are mounted in the frame 46 on both sides of an interface portion 47 of the frame 46 (Figure 3). As partially shown in Figures 2a, 2b, the fourth lateral sides of the third permanent magnet 48a are bordered by the frame 46 while only three lateral sides of the fourth paramagnet magnet 48a are bordered by the frame 46, i.e. one lateral side adjacent the interface portion 47 and two opposite lateral sides bordered by respective lateral side of the frame 46.

As can be seen in Figures 3 and 4, the first and second permanent magnets 44a, 44b are positioned on the mobile magnetic yoke 42 such that their respective polarity are opposite to each other while the third and fourth permanent magnets 48a, 48b are positioned in the non-magnetic frame 46 such that their respective polarity are opposite to each other. This magnet arrangement creates a lower magnetic circuit *C1* and an upper magnetic circuit *C2* when the magnetic Z-actuator 10 is in an extended configuration as illustrated in Figure 4.

This specific configuration of the magnetic Z-actuator 10 provides two main functions, i.e. a continuous push without electricity supply (Function 1) and an actuation action (Function 2). These two functions are achieved by an actuator made of simple electromagnetic components, thereby offering multiple advantages in terms of cost, space, mass, and efficiency.

During function 1, the lower and upper magnetic circuits *C1, C2* provides together the attraction force between the first and second coils 34a, 34b and the first and second permanent magnets 44a, 44b at zero current. This attraction force depends on the relative distance between the first and second coils 34a, 34b and the first and second permanent magnets 44a, 44b. The value can then be adjusted depending on the application.

Function 1 requires high force in continuous mode to compensate for gravity and for providing additional force to preload the upper hard stops 143. Since there is no current required, there is very low thermal deformation resulting in high position accuracy.

During function 2, both lower and upper circuits *C1, C2* contribute to the actuation force to bring the magnetic Z-actuator from a retracted configuration to an extended configuration when a current is supplied to the first and second coils 34a, 34b. The first, second, third and fourth permanent magnets 44a, 44b, 48a, 48b increase the flux generated in the coils and this results in higher output forces as compared to conventional design. Since the motion time of the mobile assembly 40 is shorter as compared to the total cycle time, a peak current is used to provide the motion to ensure high dynamics.

The magnetic Z actuator 10 is designed to provide positive Z force of 90N in continuous mode when in the extended configuration as shown in Figure 2a. There are two forces acting on the first and second permanent magnets 44a, 44b of the mobile assembly 40:
- Actuator force *Fa*: This is the total force generated by the actuator which includes the attraction & reluctance forces at zero current, and
- Force *Fm* resulting from the gravitational force on the mass of the mobile assembly 40 which needs to be compensated by the actuator.

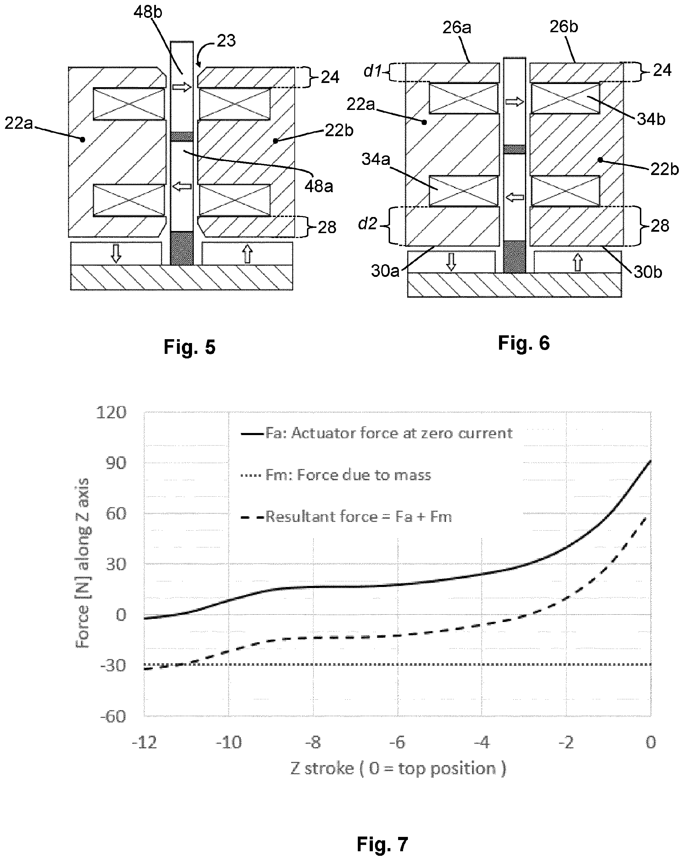

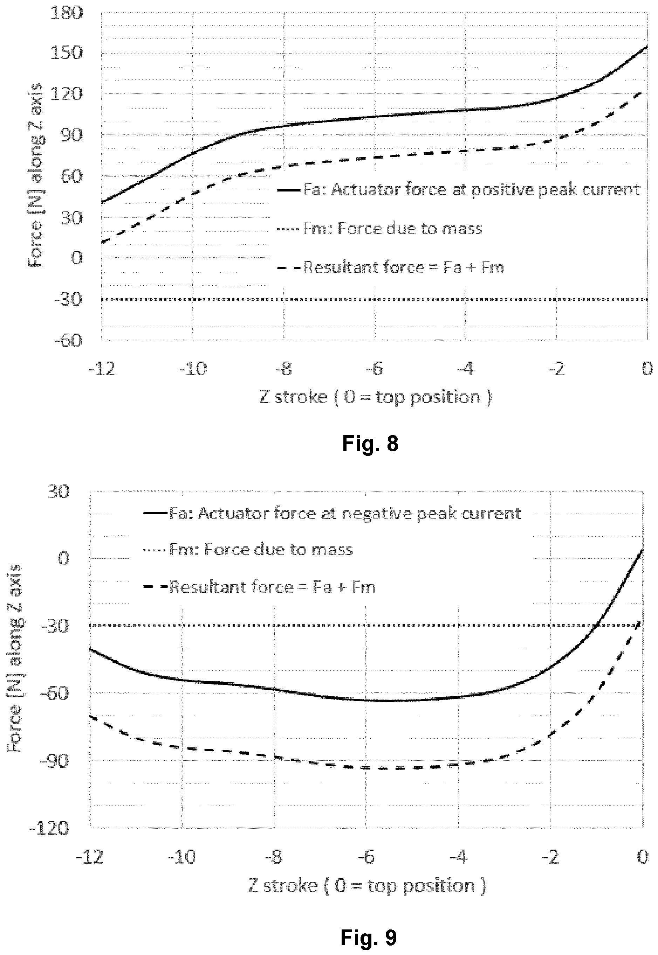

The working principle of the magnetic Z actuator may be divided in four phases, namely:
- Extended or pushing position: the magnetic Z actuator should stay at the top position providing upward push force of 90N in continuous mode. As shown in Figure 7, the configuration of the magnetic Z actuator 10 provides force of 90N wherein 30N is for the gravity compensation and the resultant 60N provides preload to the upper hard stops 143;
- Retracted position: the magnetic Z actuator should stay at the bottom position in continuous mode. Since, the attraction force is negligible at the bottom position, 30N of gravity force is sufficient to keep the actuator in its retracted configuration as shown in Figures 2b and 3;
- Pushing motion: the magnetic Z actuator should provide peak force at positive current such that the resultant force (Fa + Fm) should be positive throughout the stroke to provide the positive Z motion. As shown in Figure 8, the resultant force increases along the stroke *L* (Figure 4) of the actuator to reach a resultant force of 120N when the actuator reaches its extended configuration;
- Retraction motion: the magnetic Z actuator should provide peak force at negative current such that the resultant force (Fa + Fm) should be negative throughout the stroke to provide negative Z motion. As shown in Figure 9, the resultant force is negative along the stroke of the actuator.

The magnetic Z actuator according to the invention offers many advantages over magnetic actuator from the prior art, among which:
- High accuracy: The magnetic Z actuator 10 provides a continuous push force at the top position without any current. This results in low thermal deformation and hence high-resolution positioning.
- High dynamics: The lower and upper circuit *C1, C2* of the magnetic Z actuator 10 are complementary in nature which increases the overall flux in the first and second coils 34a, 34b. This leads to higher output forces required for motion and hence high dynamics.
- Cost effective: The magnetic Z actuator 10 consists of simple components, i.e. magnets, yoke & coils and hence is cost effective to manufacture.

Referring again to Figure 1, the mobile assembly 40 of the magnetic Z actuator 10 comprises a distal end T-shaped portion 49 on which is connected an actuating member 50. The actuating member 50 has an elongated shape, for example a rectangular shape. Two portions of the actuating member 50 are configured to press against a first and a second portion of the ring-shaped component 146 which are diametrically opposed. A vertical force can thus be applied on the ring 146 without preventing the rotation of the chuck 120.

When the magnetic Z actuator 10 is in a retracted configuration and a positive peak current is applied to the first and second coils 34a, 34b, the ring-shaped transmission component 146 moves the pin unit until the transmission component 146 abuts against the upper hard stops 143, whereupon the magnetic field circulating in the lower and upper magnetic circuit *C1, C2* ensure a preload of the upper hard stops 143 up to 60N as shown in Figure 7. Preloading the upper hard stops 143 which are connected to the respective pin holder support 140 result in high accuracy positioning of the upper surface of the pins 132.

When the magnetic Z actuator 10 is in the extended configuration and a negative peak current is applied to the first and second coils 34a, 34b, the mobile assembly is repelled by the reverses magnetic field circulating in the lower and upper magnetic circuit *C1, C2* until the first segment 134a of respective pin holder 134 abuts against the lower hard stops 144 mounted on respective pin holder support 140.

According to another embodiment and with reference to Figure 5, the magnetic Z actuator 10 comprises a first and a second E-shaped magnetic yoke 22a, 22b, whereby the upper and lower portion 24, 28 of said first and second magnetic yokes which faces one anther comprise a chamfered portion 23. This increases the reluctance force thereby reducing the intensity of the magnetic field in the lower and upper magnetic circuits *C1, C2* in order to decrease the attraction force between the stationary and mobile assemblies 20, 40 when the Z actuator 10 is in an extended configuration, thereby decreasing the pushing force when no current is applied to the coils which may be beneficial for some applications.

According to another embodiment illustrated in Figure 6, the distance *d2* between the bottom surface of respective first and second coils 34a, 34b and the bottom surface 30a, 30b of respective first and second magnetic yokes 22a, 22b is at least 1.5 times greater, for example approximately two times greater, than the distance *d1* between the top surface 26a, 26b of respective first and second magnetic yokes 22a, 22b and the top surface of respective first and second coils 34a, 34b. This is another solution to adapt the force profile at zero current.

### Reference list

Magnetic Z-actuator 10
   Housing 12
   Stationary assembly 20
      First and second magnetic yokes 22a, 22b
         E-shaped magnetic yokes
            Chamfered portion 23
         Upper portion 24
            Top surface 26a, 26b
         Lower portion 28
            Bottom surface 30a, 30b
      First and second coils 34a, 34b
   Mobile assembly 40
      Mobile magnetic yoke 42
      Horizontal permanent magnets 44a, 44b
         Rectangular parallelepiped-shaped magnets
      Non-magnetic frame 46
         Interface portion 47
      Vertical permanent magnetic 48a, 48b
         Rectangular parallelepiped-shaped magnets
      Distal end portion 49 (T-shaped portion)
         Actuating member 50
   Lower magnetic circuit *C1*
   Upper magnetic circuit *C2*
Wafer holder 100
   Rotatable unit 110
   wafer chuck 120
   Through-holes 122
   Supporting structure 124
   Pin assembly 130
      Pin 132
      Pin holder 134 (e.g. L-shaped)
         Rail 136
      Pin holder support 140
         Carriage 142
      Upper hard stops 143
      Lower hard stops 144
Transmission component 146 (e.g. ring-shaped)
Wafer holder casing 150

## Claims

1. Magnetic Z-actuator (10) comprising a stationary assembly (20) and a mobile assembly (40) configured to move relatively to the stationary assembly (20) from a first to a second stable axial position and vice versa, said stationary assembly (20) comprising a first and second magnetic yokes (22a, 22b) and a first and second coils (34a, 34b) at least partially embedded in respective first and second magnetic yokes (22a, 22b), said mobile assembly (40) comprising permanent magnets (44a, 44b, 48a, 48b), wherein the magnetic Z-actuator (10) is configured such that the first and second coils (34a, 34b) are energized only to move the mobile assembly (40) from the first to the second stable axial position and vice versa, the mobile assembly (40) remaining in either said first and second stable axial positions without providing current to said first and second coils (34a, 34b), and the mobile assembly (40) also comprises a mobile magnetic yoke (42), and a first and a second permanent magnets (44a, 44b) mounted on the mobile magnetic yoke (42) to face a bottom surface (30a, 30b) of respective first and second magnetic yokes (22a, 22b).

2. Magnetic Z-actuator (10) according to claim 1, wherein the mobile assembly is substantially T-shaped.

3. Magnetic Z-actuator (10) according to claim 1 or 2, wherein the mobile assembly (40) comprises a frame (46), and a third and fourth permanent magnets (48a, 48b) mounted in the frame (46), and wherein the frame (46) and the third and fourth magnets (48a, 48b) are arranged to move between said first and second magnetic yokes (22a, 22b).

4. Magnetic Z-actuator (10) according to the preceding claim, wherein the frame is made of a non-magnetic material.

5. Magnetic Z-actuator (10) according to claim 3 or 4, wherein the frame (46) comprises an interface portion (47), said third and fourth permanent magnets (48a, 48b) being mounted on both sides of the interface portion (47).

6. Magnetic Z-actuator (10) according to any of claim 3 to 5, wherein said first, second, third and fourth permanent magnets (44a, 44b, 48a, 48b) are rectangular parallelepiped-shaped magnets.

7. Magnetic Z-actuator (10) according to any of claims 3 to 6, wherein said first and second permanent magnets (44a, 44b) of the mobile assembly (40) are spaced away from the bottom surface (30a, 30b) of respective first and second magnetic yokes (22a, 22b) by a predetermined distance when the mobile assembly (40) is in said first stable axial position, and wherein an upper portion of the frame (46) protrudes from a top surface (26a, 26b) of said first and second magnetic yokes (22a, 22b), when the mobile assembly (40) is in said second stable axial position.

8. Magnetic Z-actuator (10) according to any of claims 3 to 7, wherein said first and second permanent magnets (44a, 44b) are magnetized in an opposite direction to form a lower magnetic circuit (C1), while said third and fourth permanent magnets (48a, 48) are magnetized in an opposite direction to form an upper magnetic circuit (C2) when the mobile assembly (40) is in the second stable axial position.

9. Magnetic Z-actuator (10) according to any preceding claim, wherein said first and second magnetic yokes (22a, 22b) are substantially E-shaped.

10. Magnetic Z-actuator (10) according to any preceding claim, wherein the upper and lower portion (24, 28) of said first and second magnetic yokes (22a, 22b) which faces one another are chamfered.

11. Magnetic Z-actuator (10) according to any preceding claim, wherein the distance *d2* between the bottom surface of respective first and second coils (34a, 34b) and the bottom surface (30a, 30b) of respective first and second magnetic yokes (22a, 22b) is at least 1.5 times greater than the distance *d1* between the top surface (26a, 26b) of respective first and second magnetic yokes (22a, 22b) and the top surface of respective first and second coils (34a, 34b).

12. A wafer holder (100) comprising the magnetic Z-actuator (10) according to any preceding claim.

13. A wafer holder (100) according to claim 12, further comprising a wafer holder casing (150), a rotatable unit (110) comprising a wafer chuck (120) rotatably mounted inside the wafer holder casing (150) and having at least three through-holes (122) and, at least three pin assemblies (130), wherein each pin assembly (130) comprises a pin (132) mounted in a corresponding through hole (122) of the wafer chuck (120) and a pin holder (134) slidably mounted on a pin holder support (140), and wherein an extremity of each pin holder (134) is connected to a transmission component (146), the magnetic Z-actuator (10) being arranged to cooperate with the transmission component (146) to move the pins (132) from a retracted position, in which the top surface of the pins (132) are set below or at the level of the surface of the wafer chuck (120), to an extended position, in which said pins (132) protrude from their corresponding through-holes (122) above the surface of the wafer chuck (120) and vice versa.

14. A wafer holder (100) according to the preceding claim, wherein the transmission component (146) is in the form of a ring adapted to cooperate with an actuating member (50) of the magnetic Z-actuator (10), the actuating member (50) being connected to two diametrically opposed portions of the transmission ring (146).

15. A wafer holder (100) according to the preceding claim, further comprising upper hard stops (144) against which the transmission ring (146) abuts under the thrust of said actuating member (50) when the first and second coils (34a, 34b) of the magnetic Z-actuator (10) are energized such that said actuating member (50) ensure a preload on the upper hard stops (144) within a range from 30 to 90 N.

## Patentansprüche

1. Magnetischer Z-Aktuator (10), der eine stationäre Baugruppe (20) und eine bewegliche Baugruppe (40) umfasst, die so ausgebildet ist, dass sie sich relativ zu der stationären Baugruppe (20) von einer ersten in eine zweite stabile axiale Position und umgekehrt bewegt, wobei die stationäre Baugruppe (20) ein erstes und ein zweites magnetisches Joch (22a, 22b) und eine erste und eine zweite Spule (34a, 34b) umfasst, die zumindest teilweise in das erste bzw. zweite magnetische Joch (22a, 22b) eingelassen sind, die bewegliche Baugruppe (40) Permanentmagnete (44a, 44b, 48a, 48b) umfasst, wobei der magnetische Z-Aktuator (10) so ausgebildet ist, dass die erste und die zweite Spule (34a, 34b) ausschließlich erregt werden, um die bewegliche Baugruppe (40) von der ersten in die zweite stabile axiale Position und umgekehrt zu bewegen, wobei die bewegliche Baugruppe (40) entweder in der ersten oder in der zweiten stabilen axialen Position verbleibt, ohne der ersten und der zweiten oberen Spule (34, 36) Strom zuzuführen, und die bewegliche Baugruppe (40) ferner ein bewegliches magnetisches Joch (42) und einen ersten und einen zweiten Permanentmagneten (44a, 44b) umfasst, die an dem beweglichen magnetischen Joch (42) derart angeordnet sind, dass sie einer Bodenfläche (30a, 30b) des ersten bzw. zweiten magnetischen Jochs (22a, 22b) gegenüberliegen.

2. Magnetischer Z-Aktuator (10) nach Anspruch 1, wobei die bewegliche Baugruppe im Wesentlichen T-förmig ist.

3. Magnetischer Z-Aktuator (10) nach Anspruch 1 oder 2, wobei die bewegliche Baugruppe (40) einen Rahmen (46) und einen dritten und vierten Permanentmagneten (48a, 48b) umfasst, die in dem Rahmen (46) angeordnet sind, und wobei der Rahmen (46) und der dritte und vierte Magnet (48a, 48b) derart angeordnet sind, dass sie sich zwischen dem ersten und zweiten magnetischen Joch (22a, 22b) bewegen.

4. Magnetischer Z-Aktuator (10) nach dem vorhergehenden Anspruch, wobei der Rahmen aus einem nichtmagnetischen Material besteht.

5. Magnetischer Z-Aktuator (10) nach Anspruch 3 oder 4, wobei der Rahmen (46) einen Schnittstellenabschnitt (47) umfasst, wobei der dritte und vierte Permanentmagnet (48a, 48b) auf beiden Seiten des Schnittstellenabschnitts (47) angeordnet sind.

6. Magnetischer Z-Aktuator (10) nach einem der Ansprüche 3 bis 5, wobei der erste, zweite, dritte und vierte Permanentmagnet (44a, 44b, 48a, 48b) rechteckige spatförmige Magnete sind.

7. Magnetischer Z-Aktuator (10) nach einem der Ansprüche 3 bis 6, wobei der erste und der zweite Permanentmagnet (44a, 44b) der beweglichen Baugruppe (40) von der Bodenfläche (30a, 30b) des jeweiligen ersten und zweiten magnetischen Jochs (22a, 22b) um einen vorbestimmten Abstand beabstandet sind, wenn sich die bewegliche Baugruppe (40) in der ersten stabilen axialen Position befindet, und wobei ein oberer Abschnitt des Rahmens (46) von einer oberen Fläche (26a, 26b) des ersten und zweiten magnetischen Jochs (22a, 22b) vorsteht, wenn sich die bewegliche Baugruppe (40) in der zweiten stabilen axialen Position befindet.

8. Magnetischer Z-Aktuator (10) nach einem der Ansprüche 3 bis 7, wobei der erste und der zweite Permanentmagnet (44a, 44b) in entgegengesetzter Richtung magnetisiert sind, um einen unteren Magnetkreis (C1) auszubilden, während der dritte und der vierte Permanentmagnet (48a, 48) in entgegengesetzter Richtung magnetisiert sind, um einen oberen Magnetkreis (C2) auszubilden, wenn sich die bewegliche Baugruppe (40) in der zweiten stabilen axialen Position befindet.

9. Magnetischer Z-Aktuator (10) nach einem der vorhergehenden Ansprüche, wobei die ersten und zweiten magnetischen Joche (22a, 22b) im Wesentlichen E-förmig sind.

10. Magnetischer Z-Aktuator (10) nach einem der vorhergehenden Ansprüche, wobei der obere und der untere Teil (24, 28) des ersten und des zweiten magnetischen Jochs (22a, 22b), die einander gegenüberliegen, abgeschrägt sind.

11. Magnetischer Z-Aktuator (10) nach einem der vorhergehenden Ansprüche, wobei der Abstand d2 zwischen der Bodenfläche der jeweiligen ersten und zweiten Spulen (34a, 34b) und der Bodenfläche (30a, 30b) der jeweiligen ersten und zweiten magnetischen Joche (22a, 22b) mindestens 1,5 mal größer ist als der Abstand *d1* zwischen der oberen Fläche (26a, 26b) der jeweiligen ersten und zweiten magnetischen Joche (22a, 22b) und der oberen Fläche der jeweiligen ersten und zweiten Spulen (34a, 34b).

12. Waferhalter (100) mit dem magnetischen Z-Aktuator (10) nach einem der vorhergehenden Ansprüche.

13. Waferhalter (100) nach Anspruch 12, der ferner ein Waferhaltergehäuse (150), eine drehbare Einheit (110), die eine Wafer-Spannvorrichtung (120) umfasst, die drehbar im Inneren des Waferhaltergehäuses (150) angeordnet ist und mindestens drei Durchgangslöcher (122) aufweist, und mindestens drei Stiftbaugruppen (130) umfasst, wobei jede Stiftbaugruppe (130) einen Stift (132), der in einem entsprechenden Durchgangsloch (122) der Wafer-Spannvorrichtung (120) angebracht ist, und einen Stifthalter (134) umfasst, der verschiebbar an einem Stifthalterträger (140) angebracht ist, und wobei ein Ende jedes Stifthalters (134) mit einer Übertragungskomponente (146) verbunden ist, wobei der magnetische Z-Aktuator (10) so angeordnet ist, dass er mit der Übertragungskomponente (146) zusammenwirkt, um die Stifte (132) aus einer zurückgezogenen Position, in der die obere Fläche der Stifte (132) unter oder auf dem Niveau der Oberfläche der Wafer-Spannvorrichtung (120) liegt, in eine ausgefahrene Position zu bewegen, in der die Stifte (132) aus ihren entsprechenden Durchgangslöchern (122) über die Oberfläche der Wafer-Spannvorrichtung (120) herausragen und umgekehrt.

14. Waferhalter (100) nach dem vorhergehenden Anspruch, wobei die Übertragungskomponente (146) die Form eines Rings aufweist, der zum Zusammenwirken mit einem Betätigungselement (50) des magnetischen Z-Aktuators (10) ausgebildet ist, wobei das Betätigungselement (50) mit zwei diametral gegenüberliegenden Teilen des Übertragungsrings (146) verbunden ist.

15. Waferhalter (100) nach dem vorhergehenden Anspruch, der ferner obere feste Anschläge (144) umfasst, an denen der Übertragungsring (146) unter dem Druck des Betätigungselements (50) anliegt, wenn die erste und die zweite Spule (34a, 34b) des magnetischen Z-Aktuators (10) erregt werden, so dass das Betätigungselement (50) eine Vorspannung auf die oberen festen Anschläge (144) in einem Bereich von 30 bis 90 N gewährleistet.

## Revendications

1. Actionneur magnétique en Z (10) comprenant un ensemble fixe (20) et un ensemble mobile (40) configuré pour se déplacer par rapport à l'ensemble fixe (20) d'une première à une seconde position axiale stable et vice versa, ledit ensemble fixe (20) comprenant une première et une seconde culasse magnétique (22a, 22b) et une première et une seconde bobine (34a, 34b) au moins partiellement intégrées dans les première et seconde culasses magnétiques respectives (22a, 22b), ledit ensemble mobile (40) comprenant des aimants permanents (44a, 44b, 48a, 48b), dans lequel l'actionneur magnétique (10) est configuré de telle sorte que les première et seconde bobines (34a, 34b) sont énergisées uniquement pour déplacer l'ensemble mobile (40) de la première à la seconde position axiale stable et vice versa, l'ensemble mobile (40) restant dans l'une ou l'autre desdites première et secondes positions axiales stables sans fournir de courant auxdites première et seconde bobines (34a, 34b), l'ensemble mobile (40) comprenant en outre une culasse magnétique mobile (42), et un premier et un deuxième aimant permanent (44a, 44b) montés sur la culasse magnétique mobile (42) pour faire face à une surface inférieure (30a, 30b) respectivement de la première et de la seconde culasse magnétique (22a, 22b).

2. Actionneur magnétique (10) selon la revendication 1, dans lequel l'ensemble mobile est sensiblement en forme de T.

3. Actionneur magnétique (10) selon la revendication 1 ou 2, dans lequel l'ensemble mobile (40) comprend un cadre (46), et un troisième et un quatrième aimants permanents (48a, 48b) montés dans le cadre (46), et dans lequel le cadre (46) et les troisième et quatrième aimants (48a, 48b) sont agencés pour se déplacer entre les première et seconde culasses magnétiques (22a, 22b).

4. Actionneur magnétique (10) selon la revendication précédente, dans lequel le cadre est constitué d'un matériau non-magnétique.

5. Actionneur magnétique (10) selon la revendication 3 ou 4, dans lequel le cadre (46) comprend une partie d'interface (47), lesdits troisième et quatrième aimants permanents (48a, 48b) étant montés de part et d'autre de la partie d'interface (47).

6. Actionneur magnétique (10) selon l'une des revendications 3 à 5, dans lequel les premier, deuxième, troisième et quatrième aimants permanents (44a, 44b, 48a, 48b) sont des aimants en forme de parallélépipède rectangle.

7. Actionneur magnétique (10) selon l'une quelconque des revendications 3 à 6, dans lequel lesdits premier et deuxième aimants permanents (44a, 44b) de l'ensemble mobile (40) sont éloignés de la surface inférieure (30a, 30b) des première et seconde culasses magnétiques respectives (22a, 22b) d'une distance prédéterminée lorsque l'ensemble mobile (40) est dans ladite première position axiale stable, et dans lequel une partie supérieure du cadre (46) dépasse d'une surface supérieure (26a, 26b) desdites première et seconde culasses magnétiques (22a, 22b), lorsque l'ensemble mobile (40) est dans ladite seconde position axiale stable.

8. Actionneur magnétique (10) selon l'une quelconque des revendications 3 à 7, dans lequel lesdits premier et deuxième aimants permanents (44a, 44b) sont magnétisés dans un sens opposé pour former un circuit magnétique inférieur (C1), tandis que lesdits troisième et quatrième aimants permanents (48a, 48) sont magnétisés dans un sens opposé pour former un circuit magnétique supérieur (C2) lorsque l'ensemble mobile (40) est dans la deuxième position axiale stable.

9. Actionneur magnétique (10) selon l'une quelconque des revendications précédentes, dans lequel lesdites première et seconde culasses magnétiques (22a, 22b) sont sensiblement en forme de E.

10. Actionneur magnétique (10) selon l'une quelconque des revendications précédentes, dans lequel les parties supérieure et inférieure (24, 28) desdites première et seconde culasses magnétiques (22a, 22b) qui se font face sont chanfreinées.

11. Actionneur magnétique (10) selon l'une quelconque des revendications précédentes, dans lequel la distance *d2* entre la surface inférieure des première et seconde bobines (34a, 34b) et la surface inférieure (30a, 30b) des première et seconde culasses magnétiques (22a, 22b) est au moins 1,5 fois supérieure à la distance *d1* entre la surface supérieure (26a, 26b) des première et seconde culasses magnétiques (22a, 22b) et la surface supérieure des première et seconde bobines (34a, 34b).

12. Porte-galette (100) comprenant l'actionneur magnétique (10) selon l'une quelconque des revendications précédentes.

13. Porte-galette (100) selon la revendication 12, comprenant en outre un boîtier (150), une unité rotative (110) comprenant un plateau (120) monté rotatif à l'intérieur du boîtier (150) et ayant au moins trois trous de passage (122) et au moins trois ensembles de goupilles (130), où chaque ensemble de goupilles (130) comprend une goupille (132) montée dans un trou de passage correspondant (122) du plateau (120) et un porte-goupille (134) monté de manière coulissante sur un support de porte-goupille (140), et où une extrémité de chaque porte-goupille (134) est reliée à un composant de transmission (146), l'actionneur magnétique (10) étant agencé pour coopérer avec le composant de transmission (146) afin de déplacer les goupilles (132) d'une position rétractée, dans laquelle la surface supérieure des goupilles (132) se trouve en dessous ou au niveau de la surface du plateau (120), à une position déployée, dans laquelle lesdites goupilles (132) dépassent de leurs trous de passage correspondants (122) au-dessus de la surface du plateau (120) et vice-versa.

14. Porte-galette (100) selon la revendication précédente, dans laquelle le composant de transmission (146) se présente sous la forme d'un anneau adapté pour coopérer avec un organe d'actionnement (50) de l'actionneur magnétique (10), l'organe d'actionnement (50) étant connecté à deux parties diamétralement opposées de l'anneau de transmission (146).

15. Porte-galette (100) selon la revendication précédente, comprenant en outre des butées supérieures (144) contre lesquelles l'anneau de transmission (146) vient en butée sous la poussée dudit organe d'actionnement (50) lorsque les première et seconde bobines (34a, 34b) de l'actionneur magnétique (10) sont alimentées de telle sorte que ledit organe d'actionnement (50) assure une précharge sur les butées supérieures (144) dans une plage allant de 30 à 90 N.
